Europäisches Patentamt

European Patent Office    (11) Publication number: **0 222 326**

Office européen des brevets    **A2**

(19)

(12) # EUROPEAN PATENT APPLICATION

(21) Application number: 86115390.6

(22) Date of filing: 06.11.86

(51) Int. Cl.⁴: **H 01 L 21/265**
**H 01 L 29/08, H 01 L 29/78**

(30) Priority: 12.11.85 US 797070

(43) Date of publication of application:
20.05.87 Bulletin 87/21

(84) Designated Contracting States:
DE NL

(71) Applicant: GENERAL ELECTRIC COMPANY
1 River Road
Schenectady New York 10022(US)

(72) Inventor: Yilmaz, Hamza
11341 Norwood Road
Raleigh North Carolina 27612(US)

(72) Inventor: Borman, Claudia Gail
2600 Route 174
Marietta New York 13110(US)

(74) Representative: Catherine, Alain et al,
General Electric - Deutschland Munich Patent Operation
Frauenstrasse 32
D-8000 München 5(DE)

(54) Method of fabricating an improved insulated gate semiconductor device.

(57) To provide a MOSFET power switching device with a low on-resistance, the body regions of active MOSFET cells are formed through a pre-existing continuous high conductivity zone created immediately adjacent the surface of a common drain region. This zone retards the depth of diffusion of the cell body regions to achieve a shorter MOSFET channel length and also forms lower resistivity portions of the device main or forward current paths; both factors contributing a lowering of the device on-resistance.

FIG. 2

## METHOD OF FABRICATING AN IMPROVED
## INSULATED GATE SEMICONDUCTOR DEVICE

The present invention relates to insulated gate power switching devices and particularly to methods for forming metal oxide silicon field-effect transistors (MOSFET) and insulated gate transistors (IGT).

## ~~Background of the Invention~~

A typical metal-oxide-semiconductor field-effect transistor (MOSFET) is ideally suited for controlling a high forward current with a relatively low bias voltage applied to its gate electrode. MOSFETs are used, along with bipolar junction transistors (BJT) and insulated gate transistors (IGTs), in power applications involving controlled switching of high currents in relatively high voltage circuits.

As is known to those skilled in the art, the typical MOSFET unfortunately exhibits a relatively high resistance while in its current conducting state. This high forward resistance introduces losses in the power circuit and produces heat in the MOSFET which must be dissipated by expensive heat sinking provisions to protect it from thermal damage. Thus, the magnitude of power current a MOSFET can safely handle is limited due to its relatively high forward resistance. Insulated gate transistors (IGT) also suffer the disadvantages of a relatively high forward or "on" resistance. As is well understood, this high forward resistance characteristic of MOSFET and IGT devices is due in part to the high resistivity of their drain regions which is necessary to provide requisite high reverse voltage blocking capability.

U.S. ~~Patent~~ A~ 4,376,286 ~~to Lidow et al.~~ discloses a method of fabricating a MOSFET having a lower forward resistance by forming a low resistance zone of the same conductivity type as the drain region adjacent the forward current conducting inversion channels created in the MOSFET cells. This high conductivity zone serves to lower the forward reistance of the MOSFET without jeopardizing its blocking voltage withstand capacity. In accordance with the Lidow et al. patent teaching, this high conductivity zone is created by a combined process of ion implantation and diffusion using a preformed mask after portions of the MOSFET cell body regions have been formed. This process is relatively complex, and difficult to control in order to establish a high conductivity region of a precise dopant impurity concentration.

It is accordingly an object of the present invention to provide an improved insulated gate device in the form of a MOSFET or IGT.

An additional object is to provide an insulated gate device of the above-character having a lower forward resistance than typical MOSFET and IGT devices.

A further object of the present invention is to provide an improved method for fabricating an insulated gate device having an uncharacteristically lower forward resistance.

Other objects of the invention will in part be obvious and in part appear hereinafter.

## ~~Summary of the Invention~~

In accordance with the present invention, a silicon semiconductor wafer is provided having a drain or bulk region of a first conductivity type and of the requisite high resistivity for the desired blocking voltage withstand capability. In accordance with an important feature of the invention, a high conductivity zone of the same conductivity type as the drain region is then formed substantially uniformly adjacent the surface of that portion of the drain region to be occupied by active MOSFET or IGT cells. Active cells are then formed by first diffusing body regions through this high conductivity zone into the drift region, and then depositing source regions into the body regions, such that the forward current conducting MOSFET channels created in these body regions are located between the source regions and the remnants of the high conductivity zone. Forward current thus flows through this high conductivity zone enroute to the drain region and the drain electrode, and thus the forward resistance is reduced. Moreover, by diffusing the body regions of the cells through the pre-existing high conductivity zone the MOSFET channel lengths are significantly shortened, thus further reducing forward or "on" resistance.

The invention accordingly comprises the features of construction and methods for achieving same which will be exemplified in the Detailed Description set forth below, and the scope of the invention will be indicated in the claims.

For a full understanding of the nature and objects of the invention, reference should be made to the following Detailed Description taken in conjunction with the accompanying drawings in which:

FIGURE 1 is a fragmentary sectional view of a vertical power MOSFET chip constructed in accordance with prior art fabrication techniques;

FIGURE 2 is a fragmentary sectional view of a vertical power MOSFET chip constructed in accordance with the methods of the present invention;

FIGURE 3 is a fragmentary sectional view illustrating the implantation of a high conductivity zone in the forward current conducting path of the MOSFET device of FIGURE 2; and

FIGURE 4 is a graph of MOSFET cell impurity consentration profiles to illustrate a feature of the present invention.

Like reference numerals refer to corresponding parts throughout the several views of the drawings.

Detailed Description

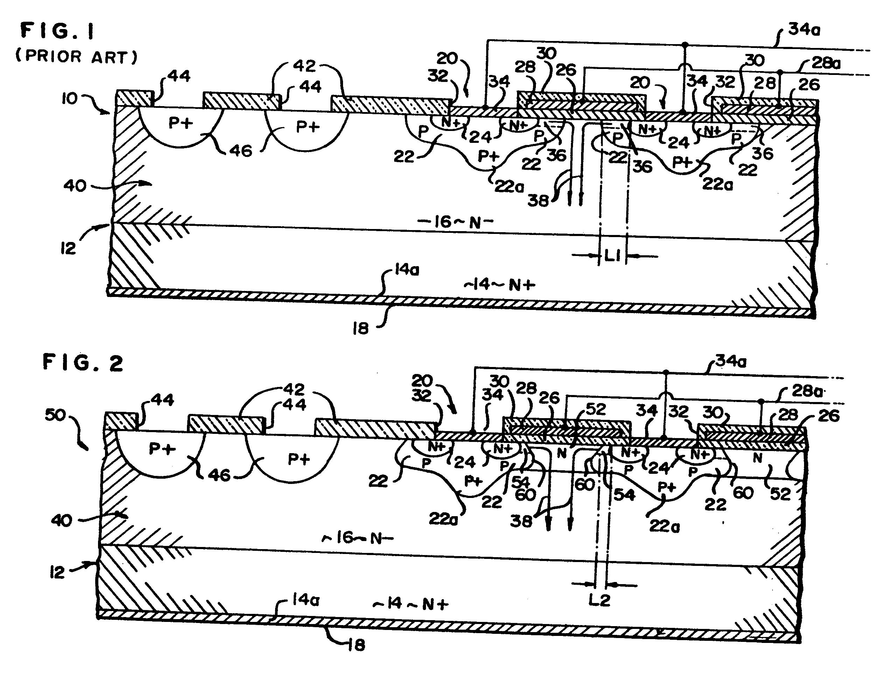

Referring now to the drawings, FIGURE 1 shows a portion of a vertical power MOSFET, generally indicated at 10, which is constructed in accordance with the prior art. Thus, MOSFET 10 includes a silicon semiconductor wafer or chip 12 having a substrate 14 of a N+ conductivity type on which is formed an epitaxial layer or drain region 16 of N- conductivity type. A distributed drain electrode 18 is formed in ohmic contact with the lower surface 14a of substrate 14. Formed into the drain region 16 through the upper surface 12a of the chip are a plurality of active cells of which two are generally indicated at 20. Each of these cells includes a P conductivity type body region 22 diffused through the chip upper surface 12a into the drain region 16 and is provided with a central, deep well P+ portion 22a serving to enhance the reverse voltage withstand capability of MOSFET 10. Using DMOS (double diffused MOS) fabrication techniques, two source regions 24 are formed in body region 22 immediately beneath the upper surface 12a of the silicon chip. Formed on the chip upper surface 12a is a gate oxide layer 26 which serves to insulatively space an overlying gate electrode 28 which is typically in the form of a distributed electrically conducting coating as illustrated diagrammatically by their parallel connection 28a. The lateral edges and upper surface of the gate electrodes 28 receive an insulative coating, indicated at 30. The separations between the illustrated segments of gate electrode 28 and the insulation thereabout serve as windows 32 through which the body region 22 and source regions 24 are diffused into drift region 16. These windows also expose portions of the cell body and source regions at upper surface 12a for ohmic contact with a distributed source electrode 34 which, like the gate electrode 28, is typically in the form of a coating of electrically conductive material, and thus the source electrodes for the various active cells are electrically connected in parallel, as indicated by the connection 34a.

As is seen in FIGURE 1, the segments of gate electrode 28 overlie the portions of the P conductivity type body region of adjacent cells 20 which separate source regions 24 from common drain region 16. As is well understood in the art, when a suitable voltage is applied to gate electrode 28, a MOSFET inversion channel, indicated at 36, is created in this intervening body portion of each cell. Forward current can thus flow from source electrode 34 through source regions 24, the MOSFET channels 36, drain region 16 and substrate 14 to drain electrode 18, as indicated by the arrows 38. Since a large segment of these current paths is constituted by the lightly doped, N- drain region 16, whose resistivity level is quite high for purposes of blocking voltage withstand, the resistance to the flow of this forward current is undesirably high. Thus, the losses introduced into the power circuit by a MOSFET device 10 can be significant at higher current levels to the point of discouraging their use in some applications. Moreover, the resulting heat generated in MOSFET 10 requires that it be adequately heat sinked to avoid thermal damage.

Completing the description of the structure of MOSFET 10 shown in FIGURE 1, there is provided a high voltage blocking region, generally indicated at 40, which is typically utilized to effectively isolate the high voltages at which the MOSFET cells 20 often operate from adjacent sections of chip 10 in which may be incorporated low voltage integrated circuit elements, such as, for example, control circuit logic elements. Thus, as seen in FIGURE 1, an insulative coating 42 is suitable apertured, as indicated at 44 to provide windows through which P conductivity type, voltage blocking rings 46 are diffused into drain region 16.

Turning to FIGURE 2, there is shown a MOSFET device, generally indicated at 50, which is constructed in accordance with the present invention to provide a forward current path whose resistance is significantly reduced. As in the case of MOSFET 10 of FIGURE 1, MOSFET 50 includes an N+ substrate 14 overlain by an N- epitaxial drain region 16. A drain electrode 18 is applied to lower surface 14a of chip 12. High voltage blocking region 40 takes the same form as that shown for MOSFET 10 in FIGURE 1. In the same fashion, the active cells 20 of MOSFET 50 consists of deep well P conductivity type body regions 22 diffused into drain region 16 and N+ source regions 24 formed into these body regions. Gate electrode 28 is insulatively spaced from these active cells by a gate oxide layer 26 and is coated over its lateral edges and top surface with an insulative coating 30. Again, the distributed nature of this gate electrode is illustrated by their parallel connection 28a. Situated within contact windows 32 in ohmic contact with the exposed surfaces of the body and source regions of each cell are segments of source electrode 34 whose distributed character is again represented by their illustrated parallel connection 34a.

Significant in terms of the present invention, is the presence in MOSFET 50 of low resistivity, high conductivity zones 52 of N conductivity type implanted in the upper portion of drain region 16 immediately beneath the major surface 12a of chip 12 such as to be disposed between the MOSFET forward current conducting inversion channels 54 of lateral adjacent active cells 20. It is thus seen that the forward current flowing through these MOSFET channels 54 must flow through these high conductivity zones 52 enroute to drain region 16 and drain electrode 18. Consequently, the segments of these current paths, indicated by arrows 38, constituted by the high conductivity zones 52 presents a lower resistance than is the case, as in MOSFET 10 of FIGURE 1, where the high resistivity N-drain region 16 extends upwardly between laterally adjacent active cells to the chip major surface 12a. Consequently, the overall resistance of these forward current paths is reduced, and this benefit is achieved without sacrificing the reverse voltage withstand capability of MOSFET 50.

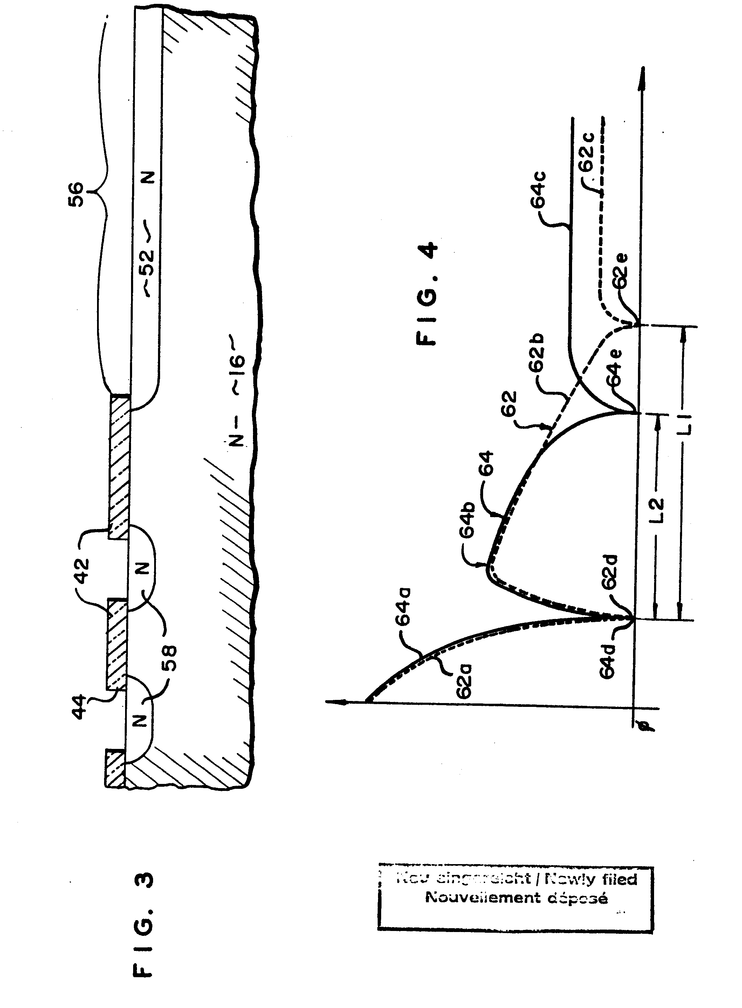

As will be described in connection with FIGURES 3 and 4, the manner in which high conductivity zones 52 are implanted in drain region 16 in accordance with the present invention is also effective in reducing MOSFET channel length. This can be seen from FIGURE 1 where the length of MOSFET channels 36 is indicated by the dimension L1, while the length L2 of the MOSFET channels 54 in FIGURE 2 are seen to be significantly shorter. Since the resistance to forward current flow of the MOSFET channels is inversely proportional to its length, a reduction in channel length provides a proportionant reduction in channel resistance. This feature of the present invention contributes to a further reduction in the on-resistance of MOSFET 50.

FIGURE 3 illustrates the unique process step in the otherwise conventional method for fabricating MOSFET 50 of FIGURE 2. After the epitaxial N- drain region 16 has been formed on the chip substrate and a silicon dioxide insulating layer has been deposited on the chip upper surface 12a, the chip is masked to remove selected portions of this insulating layer to create the windows 44 to accommodate the ultimate formation of the high voltage blocking region guard rings 46 (FIGS. 1 and 2) and to expose a section 56 of the chip surface 12a through which the active MOSFET cells 20 are to be formed. At this point of the process, in accordance with the present invention, high conductivity zone 52 is formed into the upper portion of drain region 16 uniformly over section 56 of the chip. At the same time, N type guard ring regions 58 are formed in the drain region through windows 44 over that section of the chip where the high voltage blocking region 40 will ultimately occupy. High conductivity zone 52 is achieved, in accordance with the present invention by a carefully controlled process of ion implantation, such as by subjecting the exposed chip surface 12a to a dosage of from about $5 \times 10^{10}$ to $1 \times 10^{14}$ charged particles per centimeters squared of a suitable N type impurity, such as phosphorous, arsenic or antimony. This impurity concentration is at least five times greater than the impurity concentration of N type drain region 16. The depth of the implanted high conductivity zone 52 is preferably comparable to the shallow well depth of the P type body 22, i.e., ranging from approximately 0.25 micron for low voltage rated MOSFET power switches to approximately 6 microns for those of high voltage ratings. Preferably, subsequent diffusion of this high conductivity zone to deepen its formation into the underlying drain region 16 is avoided, thus to preserve a well defined boundary therebetween.

Following implantation of high conductivity zone 52 in the active cell section of chip 12, the traditional MOSFET fabrication process is resumed by suitably masking the chip surface and forming the P type body regions 22 (FIGURE 2) through the high conductivity zone 52 and into drain region 16. The ion implantation dosage for the body regions is preferably in the range

of $1 \times 10^{13}$ to $5 \times 10^{14}$ charged particles per centimeters squared of a suitable P type impurity, such as boron, followed by a diffusion drive of 1000 - 1100°C for six to ten hours in a nitrogen environment. At the same time, the N type guard rings 58 may be converted to their P type seen in FIGURE 2. Source regions 24 are then formed in these body regions to create the multiplicity of active cells in chip 12. A typical dosage for these regions is $5 \times 10^{15}$ charge particles per centimeter squared of a suitable N type impurity such as arsenic or phosphorous. It is important to note that the implantation and subsequent diffusion of body regions 22 through high conductivity zone 52 and into the drain region, the higher impurity concentration of zone 52 relative to that of drain region 16, limits the diffusion depth of the P type body region to a greater degree, resulting in the lateral extremities of the body region assuming a blunted configuration, as indicated at 60 in FIGURE 2. Consequently, as can be seen from FIGURES 1 and 2, the MOSFET channel length L2 in MOSFET 50 is significantly shorter than the channel L1 in MOSFET 10. This phenomenon is also illustrated in FIGURE 4.

FIGURE 4 represents the impurity concentration profile of a active MOSFET cell along the portion of its forward current path extending from its source electrode to its drain region. Dash line curve 62 represents the profile of MOSFET cell 10 of FIGURE 1, while solid line curve 64 represents the profile of MOSFET cell 50 of FIGURE 2. Considering curve 62, its segment 62a corresponds to that portion of current path through source region 24, segment 62b corresponds to the current path portion through body region 22, and segment 62c represents the current path portion leading into the N-drain region 16. It is thus seen that points 62d and 62e mark the beginning and end of MOSFET channel 36 and the separation therebetween corresponds to the channel length L1 seen in FIGURE 1. Curve 64 similarly includes curve segments 64a (current path portion through the source region), curve segment 64b (current path portion through the body region), and curve segment 64c (current path portion leading into high conductivity zone 52). Thus, points 64d and 64e mark the beginning and end of MOSFET channel 54 and the separation between these points corresponds to the channel length L2 seen in FIGURE 2. It is thus seen that the higher impurity concentration of zone 52 is effective in retarding the depths of diffusion of body region 22 thus resulting in the foreshorting of the inversion channel length in MOSFET cells 50 of FIGURE 2. Thus the creation of the high conductivity zone 52 in chip 12 prior to the formation of the body and source regions of the individual MOSFET cells achieves a shorter MOSFET inversion channel, as well as provides a high conductivity zone intermediate the exits of the cell inversion channels and the drain region. Both of these features contribute to a significant reduction in the resistance of the forward current conducting paths throught a MOSFET power switch.

It will be appreciated by those skilled in the art that, rather than implanting high conductivity zone 52 into the upper portion of drain region 16, the equivalent high conductivity zone may be epitaxially grown on the upper surface of the drain region, and therefore, where the language permits, the appended claims should be so interpreted.

It will be further appreciated that the present invention can be utilized to achieve reductions in the on-resistance of P channel MOSFETs, as well as both N and P channel insulated gate transistors (IGT). Typical IGTs are identical in structure to the MOSFETs described herein with the exception that the substrate region 14 is of the opposite conductivity type from the drift region and is termed the collector region. Further, the source, body and drain regions of a MOSFET correspond to the emitter, base and drift regions of an IGT, respectively. Hence, terminology used in the claims which refers to an element of any one device is intended to include the corresponding element of the other.

It will thus be seen in the objects set forth above, among those made apparent in the preceding description, are efficiently attained and, since certain changes may be made in the above method without departing from the scope of the invention, it is intended that all matter contained in the above description or shown in the accompanying drawings shall be interpreted as illustrative and not in a limiting sense.

Having described the invention, what is claimed as new and desired to secure by Letters Patent is:

— Claims —

1. A process for fabricating a power semiconductor device, comprising:

providing a chip of silicon semiconductor material including a first region of a first conductivity type having a substantially uniform impurity concentration level and an upper surface;

forming a continuous, high conductivity zone of said first conductivity type immediately adjacent said upper surface of said first region, said zone having an impurity concentration level higher than that of said first region;

depositing impurities of a second conductivity type through said high conductivity zone and into said first region to form discrete body regions for active cells of said power semiconductor device; and

depositing impurities of said first conductivity type into said body regions to form at least one source region in each said active cell spaced from said zone by an intervening portion of said body region such that forward device current conducted through a channel formed in said intervening body region portion flows into said first region through said high conductivity zone.

2. The process defined in Claim 1, wherein said high conductivity zone is formed in said first region by ion implantation to a depth of 0.25 to 6 microns.

3. The process defined in Claim 1, wherein said high conductivity zone is formed to a depth comparable to the ultimate depth of said intervening portion of said body regions.

4. The process defined in Claim 1, wherein the impurity concentration of said high conductivity zone is at least five times greater than the impurity concentration of said first region.

5. The process defined in Claim 4, wherein said high conductivity zone is formed in said first region by an ion implantation dose of from $5 \times 10^{10}$ to $1 \times 10^{14}$ particles per centimeter squared of an impurity of said first conductivity type.

6. The process defined in Claim 5, wherein said discrete body regions are formed by an ion implantation dose of about $1 \times 10^{13}$ to $5 \times 10^{14}$ particles per centimeter squared of an impurity of said second conductivity type followed by a diffusion drive of 1000 - 1100°C for six to ten hours.

7. The process defined in Claim 6, wherein said high conductivity zone is implantated to a depth approximately equal to the ultimate depth of said intervening portion of said body regions.

8. The process defined in Claim 7, wherein said body regions are formed having a deep well portion of a depth greater and higher impurity concentration than said intervening portion.

9. The process defined in Claim 8, wherein a pair of source regions are formed in each said body region using DMOS fabrication techniques.

10. The process defined in Claim 9, which further includes the step of forming a high voltage blocking region in said first region at a location laterally adjacent said active cells of said power semiconductor device.

FIG.1 (PRIOR ART)

FIG.2

FIG. 3

44    42    56

N    N    ~52~    N

58

N-  ~16~

FIG. 4

64a

62a

64b

64

62

62b

64c

62c

64d    62d

L2

64e    62e

L1